# EUROPEAN PATENT SPECIFICATION

(11) **EP 0 286 079 B1**
(45) Date of publication and mention of the grant of the patent: **10.02.1993**
(21) Application number: 88105535.4
(22) Date of filing: 07.04.1988
(51) Int. Cl.: G01R 15/02, G01R 33/06

(54) **Sensing devices utilizing magneto electric transducers**
Sensor mit einem magneto-elektrischen Messwandler
Détecteur avec un transducteur magnéto-électrique

(30) Priority: 09.04.1987 JP 87749/87; 16.06.1987 JP 149404/87; 16.09.1987 JP 231700/87; 25.12.1987 JP 333134/87
(43) Date of publication of application: 12.10.1988
(73) Proprietor: FUJITSU LIMITED, Kawasaki-shi, Kanagawa 211 (JP)
(72) Inventor: Wakatsuki, Noboru FUJITSU LIMITED Patent Depart., Nakahara-ku Kawasaki-shi Kanagawa 211 (JP); Kurashima, Shigemi FUJITSU LIMITED Patent Depart., Nakahara-ku Kawasaki-shi Kanagawa 211 (JP); Shimizu, Nobuyoshi FUJITSU LIMITED Patent Depart., Nakahara-ku Kawasaki-shi Kanagawa 211 (JP); Endoh, Michiko FUJITSU LIMITED Patent Depart., Nakahara-ku Kawasaki-shi Kanagawa 211 (JP); Kojima, Yuji FUJITSU LIMITED Patent Depart., Nakahara-ku Kawasaki-shi Kanagawa 211 (JP); Tanaka, Akira FUJITSU LIMITED Patent Depart., Nakahara-ku Kawasaki-shi Kanagawa 211 (JP); Yoda, Hideaki FUJITSU LIMITED Patent Depart., Nakahara-ku Kawasaki-shi Kanagawa 211 (JP)
(74) Representative: Sunderland, James Harry

(56) References cited:
- GB-A- 2 004 117
- ELEKTRONIK. vol. 33, no. 13, June 1984, MUNCHEN DE pages 78 - 81; H.Hencke: "Halleffekt- und Permalloy-Stromsensoren"
- JOURNAL OF PHYSICS E. SCIENTIFIC INSTRUMENTS. vol. 19, no. 7, July 1986, ISHING, BRISTOL GB pages 502 - 515; W.Kwiatkowski et.al.: "The permalloy magnetoresistive sensors properties and applications"
- PATENT ABSTRACTS OF JAPAN vol. 8, no. 192 (P-298)(1629) 4 September 1984, & JP-A-59 079860 (MITSUNORI MATSUMOTO) 9 May 1984,
- IEEE TRANSACTIONS ON MAGNETICS. vol. Mag11, no. 5, September 1975, NEW YORK US pages 1215 - 1217; K.E.Kuijk et.al.: "The Barber pole,a linear magnetoresistive head"

## Description

The present invention relates to sensing devices utilizing magneto-resistive elements of a barber-pole type, for example for measuring electric current or electric power.

There are many types of measuring instruments for measuring electric current. Generally speaking, electric current is detected or measured by an instrument wherein a moving coil or a moving iron piece which is rotatable and serves as an indicator needle is placed between permanent magnet pole pieces or current carrying fixed coils. The instrument is of comparatively large size, and suffers from an insulation problem, especially when used in high voltage circuitry. Another type of instrument, which utilizes a current transformer, has merits in that large currents can be measured and in that the insulation problem can be mitigated, but has disadvantages in that the instrument is of large size and in that it is difficult to measure current having high frequency components.

Recently, magneto electric transducers such as Hall-effect elements and magneto-resistive elements have been utilized for measuring electric current, without direct insertion of such an element into a load circuit.

Such elements detect the magnetic field generated around a conductive wire through which load current is flowing. Therefore, such an element can be installed in isolation from the load circuit, and can have many applications for detecting and measuring purposes.

A Hall-effect element utilizes the characteristic that an electric current carrying material (usually semiconductor material) located in a magnetic field that is perpendicular to the direction of flow of the current produces a voltage perpendicular both to the current and the magnetic field. When the magnetic field applied to the Hall-effect element is generated from a load current to be measured the voltage output from the Hall-effect element indicates data that is responsive to (indicative of) load current and also to characteristics of the Hall-effect element itself. The Hall-effect element is essentially a multi-terminal (at least, three-terminal) element, and it has current input terminals and voltage output terminals.

A magneto-resistive element utilizes the characteristic that a current carrying resistance of a ferromagnetic material is increased or decreased when the material is subjected to a magnetic field. When the magnetic field is generated by a load current (to be measured), the current through the magneto-resistive element changes depending on the load current. The magneto-resistive element is essentially a two-terminal element.

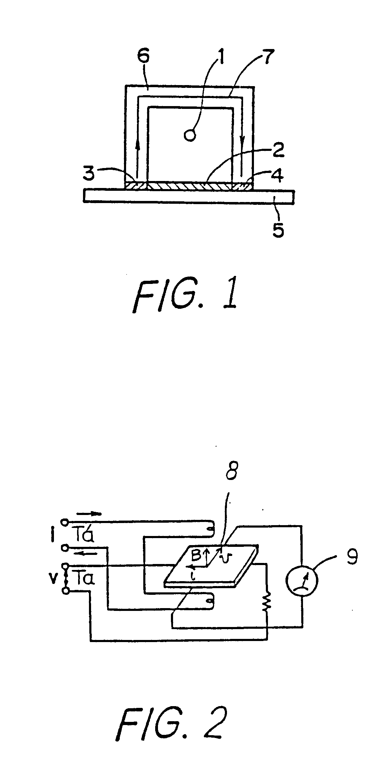

An example of a current measuring instrument utilizing a magneto-resistive element is disclosed in Japanese Tokukaisho 59-79860 by Matsumoto, which is shown in Fig. 1.

In Fig. 1, an electric current to be measured flows along a conductive wire 1 extending vertically to the plane of the Figure. A magneto-resistive layer 2 of ferromagnetic material such as Fe-Ni alloy is formed in a strip shape on an insulating substrate 5, and two terminals 3, 4 are formed on both stretched ends of magneto-resistive layer 2. A magnetic core 6 is provided in such a way that a magnetic field generated around the conductive wire 1 can easily form a magnetic loop 7 which penetrates through magnetic core 6 and magneto-resistive layer 2. When a voltage drop is measured across terminals 3 and 4, making a small constant current flow through magneto-resistive layer 2, it gives data relating to electrical resistance between the two terminals 3 and 4. When this resistance changes under the influence of the magnetic field generated by the load current (the current in the wire 1), it gives data relating to the load current.

A detector structure of this type needs a magnetic core of a comparatively large size, and moreover, terrestrial magnetism introduces an error factor into the measured data.

In a similar way, electric current can be measured using a Hall-effect element as shown in Fig. 2. When terminals Ta are connected to a constant voltage source V which makes a small current i flow through Hall-effect element 8, and further when a load current I flows between terminals Taʹ generating a magnetic field B vertical to the Hall-effect element 8, then a voltage v (Hall voltage) is detected, the voltage being induced across Hall-effect element vertical to both i and B.

The Hall-effect element shown in Fig. 2 can be used for measuring electric power. When the terminals Ta are connected to a power source which is simultaneously supplying the load current through terminals Taʹ, an induced Hall voltage v which is proportional to electric power can be measured, because the current i through Hall-effect element 8 is proportional to the voltage V of the power source and the applied magnetic field B is proportional to the load current I. When a DC power source is used, a DC output is directly obtained. On the other hand, when an AC power source is used, the output voltage from the Hall-effect element gives a fluctuating waveform of a doubled frequency, because the polarities of both the magnetic field and the direction of current flow in the Hall-effect element are reversed every half cycle. When the output data is averaged, it indicates electric power.

When a Hall-effect element is utilized in a measuring instrument, it is necessary to shield the element from external magnetic fields, especially from terrestrial magnetism. This increases the size of the instrument.

Journal of Physics E-Scientific Instruments, 19, (1986), July, No. 7, Bristol, Great Britain, pages 502 to 515, in an article entitled "The permalloy magnetoresistive sensors-properties and applications", discloses the use of permalloy magneto-resistive elements for sensing magnetic field.

The use of barber-pole type sensors, for example in a bridge arrangement, is disclosed. Current sensors are disclosed.

According to the present invention there is provided a sensing device utilizing magneto-resistive elements of a barber-pole type, said device comprising:-
a conductive member, for example a conductive wire, through which an electric current to be sensed flows, generating a magnetic field around said conductive member;
a substrate;
a plurality of said magneto-resistive elements formed on the substrate, each or at least one of which elements has a function of outputting an electrical signal responsive to said magnetic field;
means for locating the conductive member in close proximity to said magneto-resistive elements, or to said at least one of the elements; and
means for combining electrical signals output from the magneto-resistive elements and outputting a combined signal the value of which is dependent upon the said electric current;
characterised in that
the magneto-resistive elements of the plurality are arranged in a doughnut-ring shape around a central region and each magneto-resistive element of the plurality has a meandering pattern, said pattern comprising alternate outward strips, going away from said central region almost along a radial direction, and return strips going back towards said central region.

An embodiment of the present invention can provide a sensing device for electric current, of a simple and compact structure utilizing magneto electric transducers.

An embodiment of the present invention can provide a sensing device which can be used over a wide frequency range, from DC to a high frequency.

An embodiment of the invention can provide a sensing device which can be used for detecting electric power as well as electric current.

An embodiment of the present invention can provide a sensing device of compact size and high precision which can be used for measuring both direct (DC) current and alternating (AC) current.

Reference is made, by way of example, to the accompanying drawings, in which:-
Fig. 1 is a schematic plan view of a magneto-resistive element disclosed in Japanese Tokukaisho 59-79860;
Fig. 2 is a schematic illustration of a measuring circuit for electric power, using a Hall-effect element;
Fig. 3 illustrates schematically a basic configuration used in embodiments of the present invention;
Fig. 4 illustrates schematically a basic sensing device configuration used in embodiments of the present invention, wherein magneto-resistive elements are disposed to form a bridge circuit;
Fig. 5 illustrates schematically another basic sensing device configuration used in embodiments of the present invention, wherein two magneto-resistive elements are connected in series;
Fig. 6 is a schematic block diagram, illustrating measurement of electrical power using four magneto-resistive elements, in accordance with an embodiment of the present invention;
Fig. 7 is another schematic block diagram, illustrating measurement of electrical power using two magneto-resistive elements, in accordance with an embodiment of the present invention;
Fig. 8 shows a magneto-resistive element of a barber-pole type disclosed in I.E.E.E. Trans. Magnetics, 1975;
Fig. 9 is a graph illustrating linear change of electrical resistance of a barber-pole type magneto-resistive element with change of a magnetic field applied vertically to the element;
Fig. 10 is a plan view illustrating the pattern of magneto-resistive elements forming a bridge circuit in a sensing device embodying the present invention;
Fig. 11 is a cross-section taken along chain lin IV-IV of Fig. 10;
Fig. 12 illustrates in more detail dimensions of the barber-pole pattern of Fig. 10;
Fig. 13 is an enlarged view of a small portion B of Fig. 10;
Fig. 14 illustrates another barber-pole pattern, which can be used in a barber-pole type magneto-resistive element in a sensing device embodying the present invention;
Fig. 15 is a perspective view of a sensing device embodying the present invention assembled in a module, with a front surface broken away;
Fig. 16 is a plan view illustrating the pattern of magneto-resistive elements in another sensing device embodying the present invention;
Fig. 17(a) and 17(b) are a top view and an elevational view, respectively, illustrating relative dispositions of a conductive wire and a sensing device;
Fig. 18 is a graph illustrating test results obtained upon measurement of electric current utilizing an embodiment of the present invention;
Fig. 19 illustrates schematically another pattern, similar to that of Fig. 10, offering more convenient initial magnetization of a device embodying the present invention;
Fig. 20 illustrates schematically another pattern, similar to that of Fig. 16, offering more convenient initial magnetization of a device embodying the present invention;
Fig. 21 shows a cross-section of a through-hole formed in a substrate of a device embodying the present invention;
Figs. 22(a) to 22(c) show a top view, bottom view, and a cross-section of a through-hole in a silicon substrate of a device embodying the present invention, which through-hole is formed by an anisotropic etching process;
Figs. 23(a) to 23(d) show a top view, bottom view, and two cross-sections of a through-hole in a silicon substrate of a device embodying the present invention, which through-hole is formed by an anisotropic etching process in a different way from Figs. 22(a) to 22(c);
Fig. 24 is a schematic block diagram of a device for measuring electric power, embodying the present invention, utilizing two sensing device units;
Fig. 25 is a schematic circuit diagram of a device for measuring electric power, embodying the present invention, when a high voltage of alternating current is involved;
Figs. 26(a) to 26(c) are, respectively, a diagram illustrating relationship of voltage, current and power, a circuit diagram of a device embodying the present invention for measuring electric power when a pure resistive load and 10 Hz AC power source are used, and test results obtained with the device, and
Figs. 27(a) to 27(c) are, respectively, a diagram illustrating voltage, current and power, a circuit diagram of a device embodying the present invention for measuring electric power when a pure capacitive load and 100 Hz AC power source are used, and test results obtained with the device.

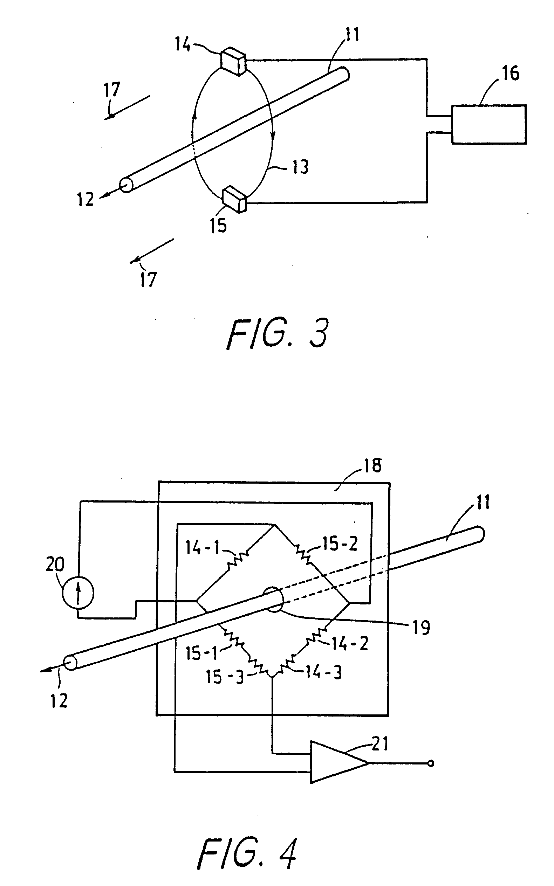

Fig. 3 illustrates schematically a basic configuration employed in embodiments of the present invention. An electric current 12 to be measured flows through a conductive wire 11 forming a magnetic field 13 around the conductive wire 11. Magneto electric transducers 14, 15 are arranged at circumferentially opposite positions about conductive wire 11. A combining unit 16 is provided for the outputs from the magneto electric transducers. When each of magneto electric transducers 14, 15 has the same characteristic and is subjected to the magnetic field 13 generated by the flow of electric current 12, the direction of magnetic field being the same for each of the transducers, then each transducer outputs the same voltage having the same polarity. Therefore, when these outputs are combined using combining unit 16 such as a differential amplifier, the output therefrom is doubled.

However, external disturbing or perturbing magnetic fields, such as the terrestrial magnetic field, exert opposite polarity influences on the magneto electric transducers, and therefore the effects of such fields are cancelled in the differential amplifier.

Fig. 4 schematically illustrates a configuration employed in embodiments of the present invention, wherein a plurality of magneto electric transducers is used, forming a bridge circuit. The bridge outputs an unbalanced (out-of-balance) current, which is caused by resistance changes of transducers (in this case, magneto-resistive elements 14-1 to 14-3 and 15-1 to 15-3 are used) due to the magnetic field generated by the electric current 12. This type of detector has a high sensitivity and improved precision in measurement.

In an actual structure, magneto-resistive elements 14-1 and 14-2, and elements 15-1 and 15-2, are arranged at circumferentially (diametrically) opposite positions with regard to the central conductive wire 11. As a magneto-resistive element, a barber-pole type element (explained below) is preferred.

The magneto-resistive elements are formed on a substrate 18 of a material such as glass, silicon or the like, having a through-hole 19 at the centre of the bridge circuit, through which conductive wire 11 penetrates. A constant current source or a constant voltage source 20 is connected to a first pair of terminals of the bridge, and an amplifier 21 is connected to the other pair of terminals of the bridge and amplifies the unbalance (out-of-balance) current. Magneto-resistive elements are formed by depositing magneto-resistive material on the substrate and patterning the material by a photolithography technique. Magneto-resistive elements 14-3 and 15-3 are formed for adjusting the balance of the bridge of four magneto-resistive elements 14-1, 14-2, 15-1 and 15-2.

When current 12 flows through conductive wire 11, it forms a magnetic field therearound. Because the four magneto-resistive elements are formed in a manner such that the magnetic field results in a resistance increase of magneto-resistive elements 14-1 and 14-2 and, on the other hand, a resistance decrease of magneto-resistive elements 15-1 and 15-2, or vice versa, the equilibrium of the bridge is lost as a result of the application of the magnetic field and an unbalanced (out-of-balance) voltage appears at the output terminals of the bridge. The output of amplifier 21 indicates values proportional to the current 12.

When AC current flows through conductive wire 11, an alternating output voltage can be obtained. The output of amplifier 21 also exhibits an alternating waveform which is proportional to current 12.

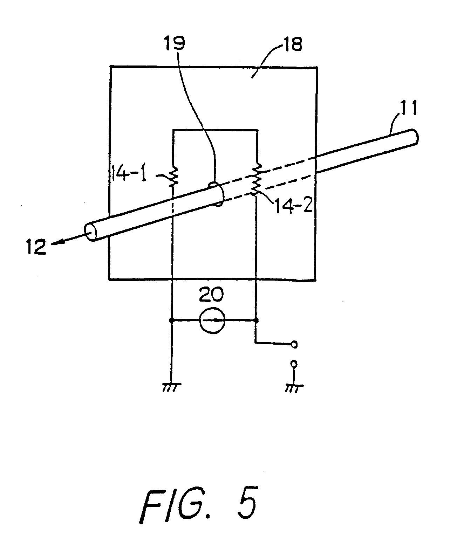

A plurality of magneto-resistive elements having the same polarity and connected in series can also be used in detecting electric current. A configuration employed in embodiments of the present invention is illustrated in Fig. 5, wherein magneto-resistive elements 14-1 and 14-2 are formed on a substrate 18 and arranged at circumferentially diametrically opposite positions with regard to a through-hole 19. Magneto-resistive elements 14-1 and 14-2 are connected in series and the ends thereof are connected to a constant current source 20. The voltage drop across the two magneto-resistive elements 14-1 and 14-2 changes in dependence upon the total resistance value which is responsive to the magnetic field caused by electric current 12. By reading the indication of meter 20, current 12 can be measured after calibration. This device configuration is simpler than that of Figs. 3 and 4.

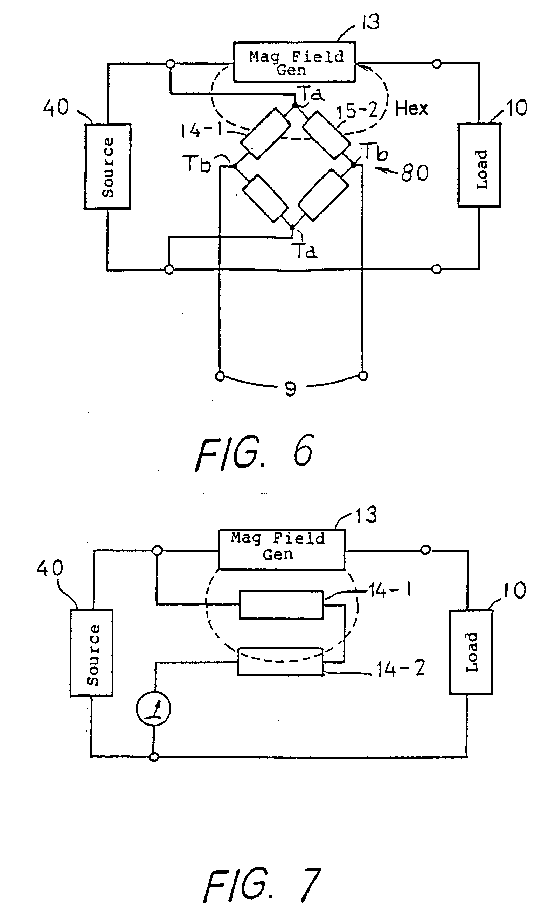

A sensing device embodying the present invention can be utilized for detection and measurement of electric power. Fig. 6 is a block diagram of a device for measurement of electric power consumed in a load 10. A bridge structure 80 of four magneto-resistive elements, such as is shown in Fig. 4, is used, and is connected in parallel with power source 40. A magnetic field generator 13 is inserted in series with load 10. Magnetic field generator 13 may be a simple coil or a conductive wire 11 penetrating through a through-hole 19 as in Fig. 4. Further, a conducting wire or a coil carrying electric current disposed near the surface of bridge 80 will function as a magnetic field generator 13. However, at least one of magneto-resistive elements should be disposed under the influence of magnetic field generator 13. Fig. 6 illustrates a condition in which two magneto-resistive elements 14-1 and 15-2 are disposed to receive the effect of magnetic field generator 13.

Power source 40 is connected between terminals Ta of the bridge 80, but no output is detected from terminals Tb when the bridge 80 is in a balanced condition. When a load current flows through load 10 and magnetic field generator 13, magnetic field generated thereby causes the resistance values of magneto-resistive elements 14-1 and 15-2 to change, one element increasing and the other decreasing, and this causes an unbalance (out-of-balance) voltage to be output at terminals Tb. Further, the output voltage at terminals Tb also changes proportionally to the voltage of power source 40. Therefore, the output voltage at terminals Tb is proportional to a product of load current and source voltage, which means electric power supplied to load 10.

Another device embodying the present invention, for measuring electric power, is shown in Fig. 7, wherein an arrangement of magneto-resistive elements similar to that of Fig. 5 is utilized. Two magneto-resistive elements 14-1 and 14-2, having the same characteristic, are connected in series and inserted in parallel with power source 40. Load current produces a magnetic field from magnetic field generator 13, and the magnetic field causes resistance change in magneto-resistive elements 14-1 and 14-2, resulting in changing detector current. On the other hand, detector current also changes proportionally to the voltage of power source 40. As a result, the component of current change through the detector circuit is proportional to a product of load current and source voltage, in other words, electric power supplied to load 10. In this method, detector current flows through magneto-resistive elements even when the load is cut off. In a device using a bridge as shown in Fig. 6, no output is observed when the load circuit is cut off; therefore, the precision of the arrangement of Fig. 6 is higher than that of the arrangement of Fig. 7.

Sensing devices embodying the present invention can utilize any of several types of magneto electric transducers, of which Hall-effect elements and magneto-resistive elements are representative examples.

A Hall-effect element utilizes the characteristic that an electric current carrying material located in a magnetic field that is perpendicular to the direction of the current produces a voltage perpendicular to both the current and the magnetic field.

On the other hand, a magneto-resistive element utilizes the characteristic that a current carrying resistance of a ferromagnetic material is increased or decreased when the material is subjected to a magnetic field.

These elements can be utilized to detect or measure an electric current by sensing the magnetic field produced by the electric current.

As the materials of Hall-effect elements, semiconductors such as InSb, InAs, Ge and Si are utilized.

As the materials of magneto-resistive elements, ferromagnetic materials such as Fe-Ni (permalloy), Co-Ni, etc., are widely used because of superior characteristics in an ambient temperature change.

Further, as a magneto electric transducer, a Hall-effect element should be treated as a multi-terminal element, whilst a magneto-resistive element can be treated as a two-terminal element. Magneto-resistive elements have another advantage in that intricate patterns of a plurality of elements can be formed on a substrate using photolithography technology.

A barber-pole type of magneto-resistive element, disclosed in the following reference, is of interest.

K. E. Kuijk et al, "The Barber Pole, a Linear Magnetorestive Head", I.E.E.E. Trans. Magnetics, Vol. Mag-11, No. 5, Sept. 1975.

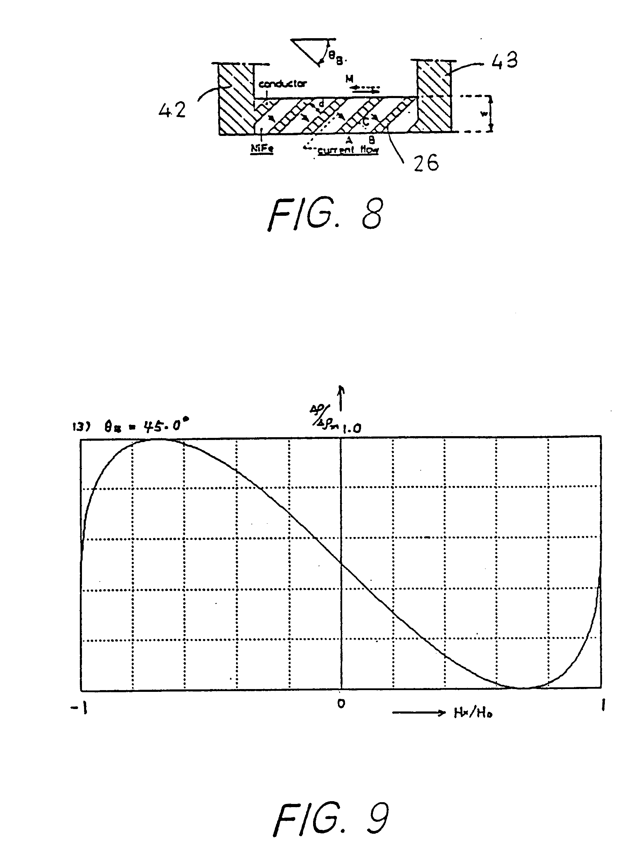

It is disclosed that slanted stripes 26 of good conductor are formed on a patterned layer of ferromagnetic material, as shown in Fig. 8, whereby the angle of the stripes with reference to the easy axis of magnetization (shown by arrow M) is set as approximately 45°. As illustrated in Fig. 9, electrical resistance between terminals 42 and 43 changes almost linearly around the abscissa value Hx/Ho = 0, where Ho means the saturation field of the magneto-resistive layer and Hx means the applied transversal magnetic field to the axis M.

The ordinate in Fig. 9 indicates a ratio of resistivity change (for a particular value of Hx/Ho) to the maximum resistivity change. Sensing devices embodying the present invention utilize this characteristic of resistivity or resistance change of a magneto-resistive element.

In Fig. 9, the slant (slope) of resistivity reverses its direction with regard to a vertical line through abscissa 0 depending on (a) the direction of an applied magnetic field, (b) the slant direction of the barber-pole pattern, (c) the direction of initial magnetization of the magneto-resistive layer, and (d) the direction of the current flowing through the magneto-resistive element. Therefore, when a plurality of magneto-resistive elements are formed and connected mutually on a substrate and utilized as a sensing device, the slant direction of barber-pole patterns or the direction of initial magnetization should be determined taking into consideration the particular application of the magneto-resistive elements.

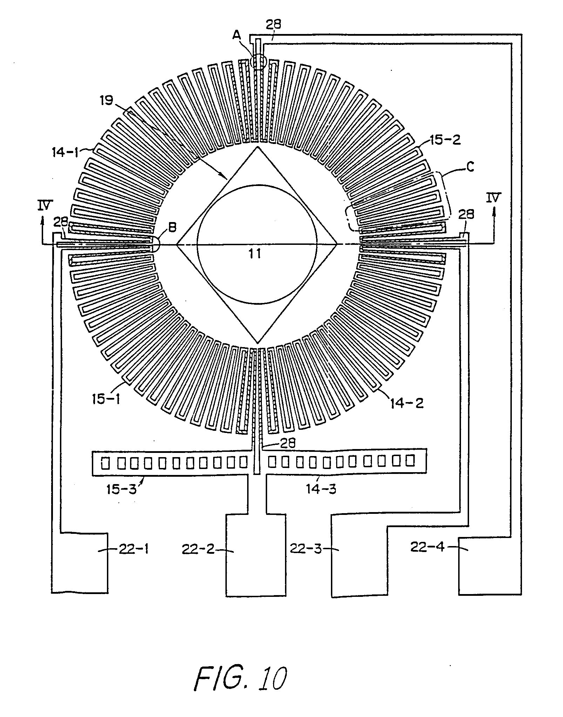

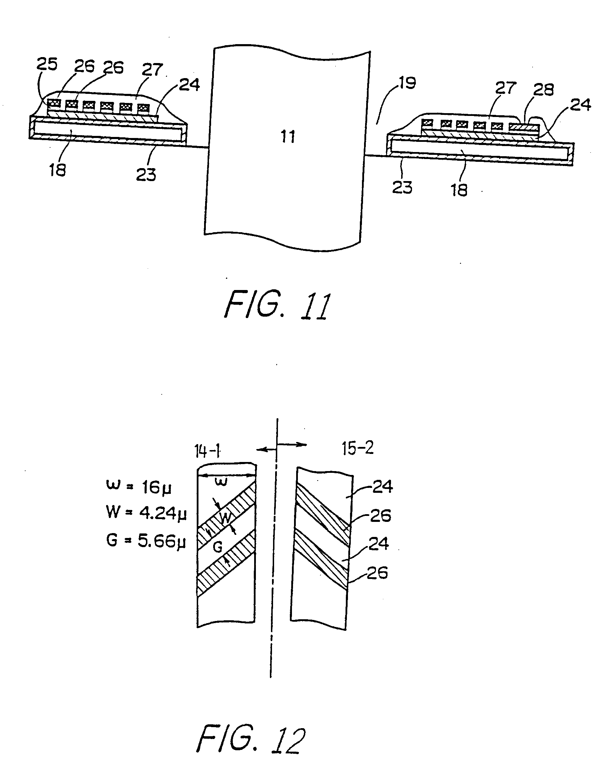

Figs. 10 to 14 illustrate a detailed structure of a sensing device embodying the present invention having a basic configuration as shown in Fig. 4. Fig. 10 is a plan view showing the pattern of magneto-resistive elements formed on a substrate, and Fig. 11 is a cross-section taken along chain line IV-IV in Fig. 10, with vertical dimensions more exaggerated in Fig. 11. Patterns of four magneto-resistive elements 14-1, 14-2, 15-1 and 15-2 are formed in a doughnut shape on the substrate 18, each element having a meandering pattern. Four bonding pads 22-1 to 22-4 are formed on the substrate and are connected to respective vertices of the bridge circuit.

The pattern of the magneto-resistive elements is formed as follows. First, an insulating layer 23, for example a silicon dioxide (SiO₂) layer, is formed on silicon substrate 18. Next, a thin layer 24 of ferromagnetic materials, such as permalloy (Fe-Ni) alloy, is deposited on insulating layer 23, and ferromagnetic layer 24 is then patterned using photolithography technology, resulting in the formation of a pattern as shown in Fig. 10.

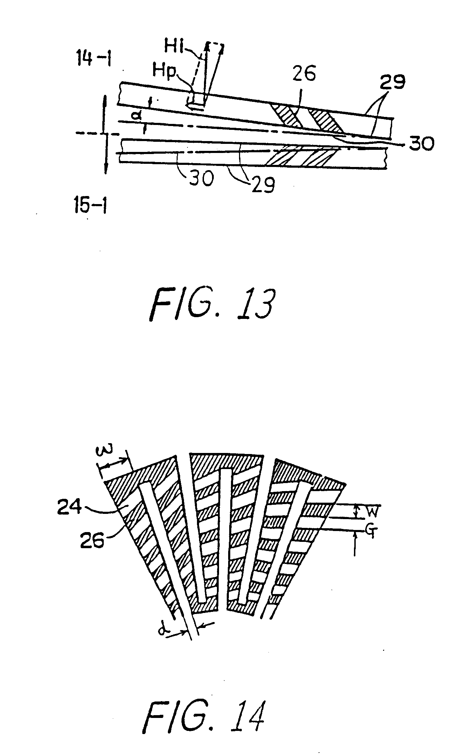

Fig. 13 shows an enlarged view of small portion B of Fig. 10. Each side line 29 shown in Fig. 13 of meandering permalloy pattern deviates by an angle α from chain line 30 which extends radially from the centre of through-hole 19, conductive wire 11 penetrating therethrough. Angle α is, for example, less than 5°. All four meandering patterns of magneto-resistive elements 14-1, 14-2, 15-1 and 15-2 are formed with the longitudinal axis of each meandering strip being displaced by angle α in the same direction. The reason for this is that the permalloy pattern of a meandering strip has only geometrical anisotropy when formed, and therefore it is necessary that the permalloy pattern be given an electromagnetic anisotropy by an initial magnetization. This is achieved by passing a heavy current through conductive wire 11, generating a magnetic field Hi therearound. As shown in Fig. 13, the direction of magnetic field Hi is vertical to radial chain line 30; therefore, it has an angle 90° - α with respect to a side line 29. A component magnetic field Hp is applied to the strip pattern in the longitudinal direction thereof, which is equal to Hi x sin α. When angle α is assumed to be a few degrees and the magnitude of Hi is assumed to be 800 Oe, then Hp of 4 to 50 Oe contributes to give an electromagnetic anisotropy.

After initial magnetization, a contact layer 25 of tantalum molybdenum (TaMo) or chromium, and subsequently a conductive layer 26, for example a gold layer, are deposited and then patterned. The dimensions of the barber-pole pattern are indicated in Fig. 12. As further seen in Fig. 12, the directions of the slanted patterns 26 are reversed from one to the other of two neighbouring elements 14-1 and 15-2, which makes resistance of these two neighbouring elements change in opposite directions when used in the bridge circuit. The angle of slant is usually chosen to be about 45°, and this makes the use of a bias magnetic field unnecessary, and a linear change of resistance with respect to applied magnetic field can be obtained.

Four bonding pads 22-1 to 22-4, connecting lines 28 and two adjusting patterns 14-3 and 15-3 are simultaneously formed with magneto-resistive elements and finally protective layer 27 is coated on the entire surface. The adjusting patterns 14-3 and 15-3 are used to trim the resistance balance of the bridge circuit.

Through-hole 19 is formed in the substrate 18 before the permalloy deposition process. An anisotropic wet etching process onto a (1, 1, 0) surface of silicon monocrystal substrate is suitable to form a rhomboid shape hole as shown in Fig. 10.

Patterning alternative to that described above can be used in the device of Fig. 10.

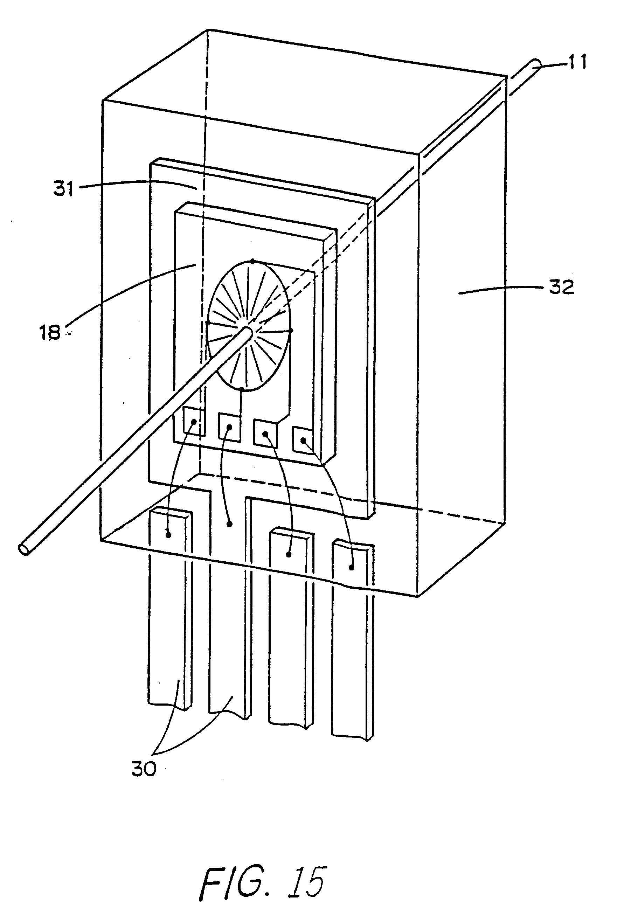

Fig. 14 shows an enlarged view of this alternative permalloy pattern corresponding to a part C of magneto-resistive element 15-2 of Fig. 10. This pattern is formed in a manner such that the gap dimension d between two neighbouring permalloy strips is maintained almost constant over the entire pattern surface. Therefore, the width w of permalloy strip 24 gradually increases as the strip extends radially outwardly (away from through-hole 19). The width W of conductive layer 26 and gap G are maintained constant throughout the pattern. The magnetic field generated by current flowing through conductive wire 11 decreases gradually as distance from conductive wire 11 increases. However, in this case, because the lateral width w of each radial permalloy strip increases with increasing distance from conductive wire 11, the corresponding decrease in magnetic field is somewhat compensated, and improved characteristics for the sensing device can be expected.

Fig. 15 shows a schematic perspective view of a sensing device embodying the present invention assembled in a module, shown with a front surface of the module broken away. Lead terminals 30 are used for connections to an output amplifier and to an input power source, and a lead frame 31 is used to fix the substrate 18 in an exterior frame 32. When conductive wire 11 is connected in the load circuit, load current is measured by detecting the magnetic field around the sensing device.

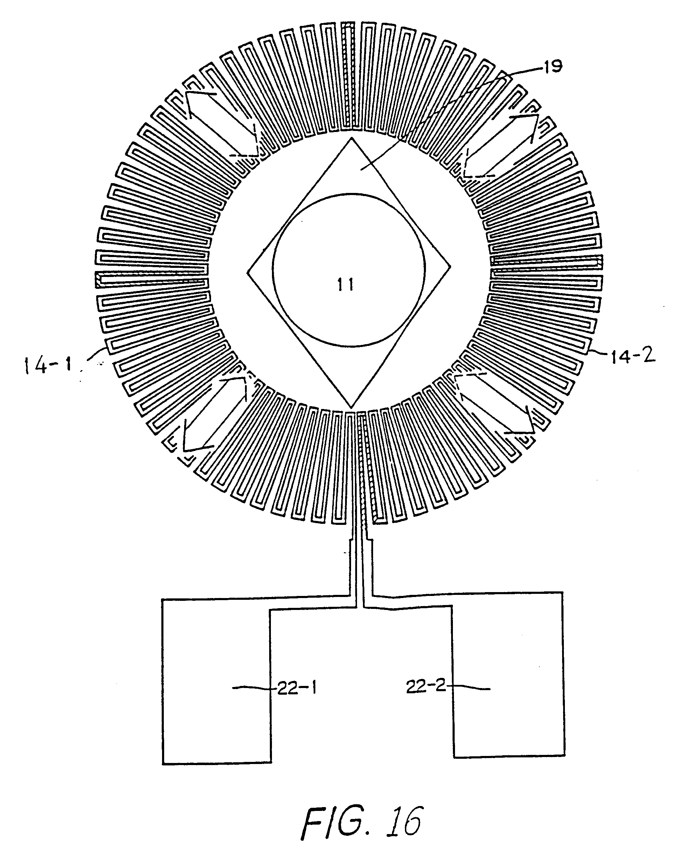

Fig. 16 illustrates a sensing device embodying the present invention, utilizing the basic configuration of Fig. 5, with barber-pole type magneto-resistive elements. In Fig. 16, barber-pole type magneto-resistive elements 14-1 and 14-2 are arranged symmetrically in left and right halves of the Figure. All directions of initial magnetization indicate either outwardly diverging direction from the through-hole 19 or inwardly converging direction thereto. Bonding pads 22-1 and 22-2 are connected to a constant current source or to a constant voltage source, and further connected to an amplifier for measuring the voltage drop across the bonding pads. The pattern of permalloy layer shown in Fig. 16 is similar to that shown in Figs. 12 and 13, wherein the width w of permalloy layer has the same value regardless of distance from the through-hole and the longitudinal direction of each pattern strip of permalloy deviates by a small angle from a radial direction from the through-hole centre, as shown in Fig. 13. A barber-pole strip pattern such as is shown in Fig. 14 can alternatively be employed. Because the slant angle of the conductive layer 26 of the barber-pole pattern is the same for both magneto-resistive elements 14-1 and 14-2, the direction of resistance change (increase or decrease) is the same for both magneto-resistive elements 14-1 and 14-2.

In measurement utilizing pattern structures as shown in Figs. 10 and 16, conductive wire 11 penetrates through through-hole 19.

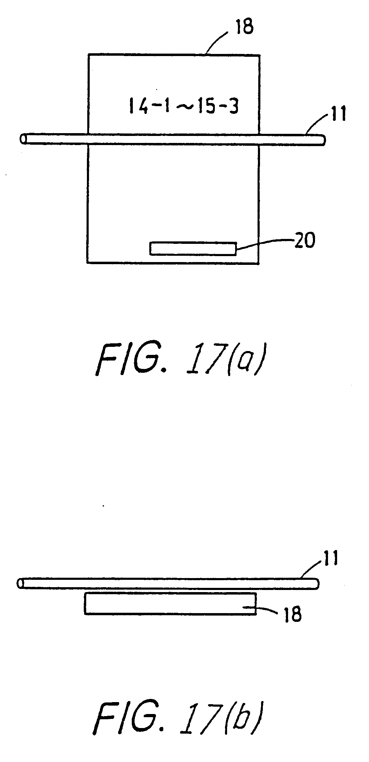

On the other hand, sensing devices embodying the present invention can be used for measuring electric current flowing through a conductive wire 11 extending in parallel with a substrate 18 of the sensing device and located in close proximity thereto, as illustrated in Figs. 17(a) and 17(b).

Fig. 17(a) is a top view and Fig. 17(b) an elevation view. With the condition that conductive wire 11 is fixed in parallel with substrate 18, magneto-resistive elements being formed thereon, it is desirable that the conductive wire passes right above the centre region of the pattern of magneto-resistive elements. Further, conductive wire is usually circular or round in cross-section, but, in the case of Figs. 17(a) and 17(b), conductive wire having a flat shape of a rectangular cross-section, for example a ribbon wire, is effective to make the magnetic field applied to the magneto-resistive elements more uniform.

When a sensing device embodying the present invention is used in this way, the magnetic field generated by conductive wire of Figs. 17(a) and 17(b) exhibits only one direction on the substrate, for example, X-direction or Z-direction only. Therefore, the slant direction of conductive layers of the barber-pole patterns should be reversed with reference to the X-axis or the Y-axis, depending on the direction of conductive wire above the substrate.

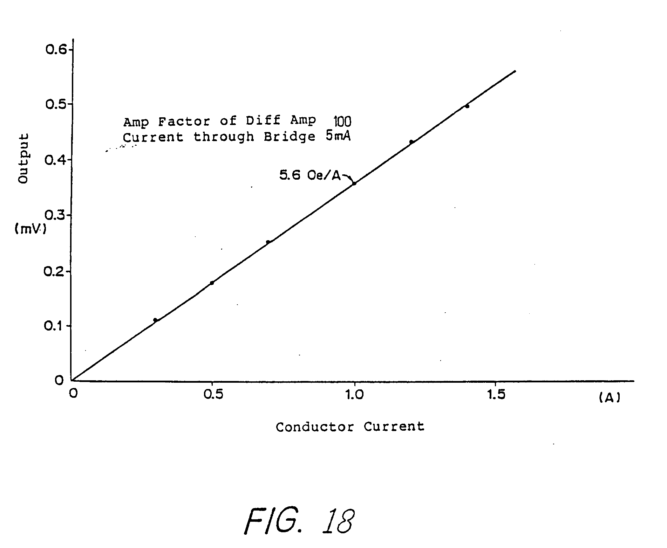

A sensing device embodying the present invention having a bridge pattern as illustrated in Fig. 10 was tested in the configuration of Figs. 17(a) and 17(b), maintaining a gap of 0.4 mm between conductive wire 11 and the substrate 18. The results are indicated in Fig. 18, where the abscissa shows electric current measured and the ordinate shows the output of the amplifier (c.f. 21 in Fig. 4). The magnitude of the magnetic field per 1.0 ampere of current shows 5.6 Oe/A on the substrate.

A plurality of sensing devices, each comprising a plurality of magneto-resistive elements arranged in a doughnut shape on a substrate, show improved sensitivity and characteristics when properly arranged and mutually connected. For example, a plurality of sensing devices may be stacked with the same conductive wire in each through-hole. When the outputs from the sensing devices are combined, sensitivity is multiplied. When the outputs of a plurality of sensing devices are combined, each device having a slightly different characteristic from the others, an improved characteristic can be obtained.

In applying the measuring arrangement of Figs. 17(a) and 17(b), two sensing units can be disposed on opposite sides of the conductive wire, resulting in a doubled output. Alternatively, the conductive wire can be formed in a coiled shape, wherein a plurality of turns of the conductive wire, carrying current in the same direction, are arranged to pass above a sensing unit.

Sensing elements or units such as are shown in Figs. 10 and 16 have a direction of initial magnetization which is either outwardly going (diverging) from the unit centre or concentrating inwardly (converging) to the centre.

The handling or operation of initial magnetization explained previously with reference to Fig. 13, wherein large current is made to flow along the centre conductive wire, is troublesome. Therefore, a simpler method is desired. The use of an electromagnet, wherein one pole is arranged at the centre of the ring-shaped pattern and another pole is arranged at a peripheral region thereof, is also troublesome.

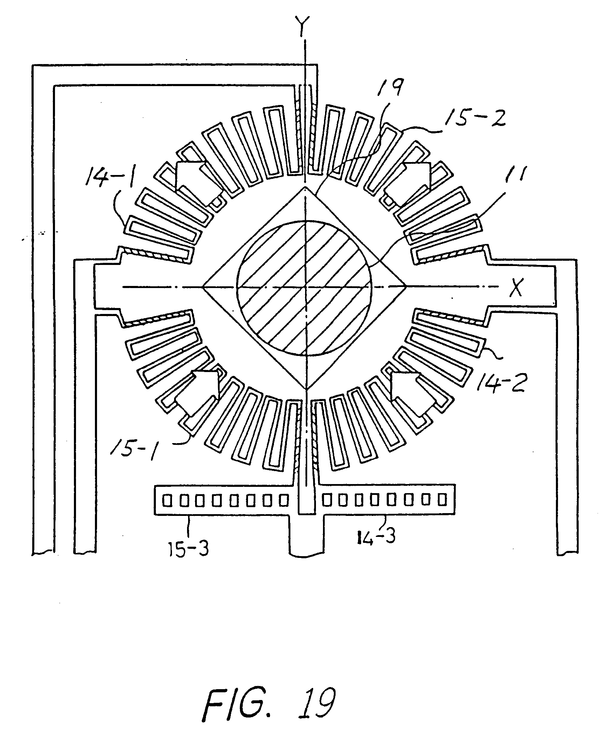

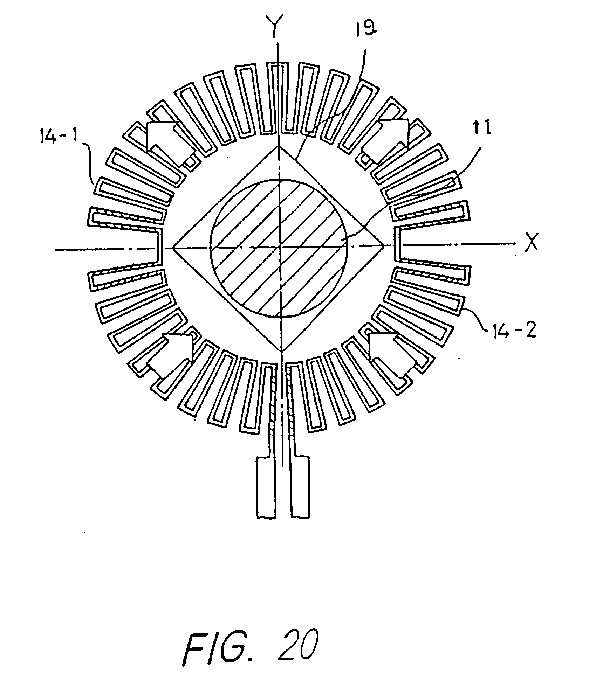

To provide for improvement in relation to these problems, a configuration can be employed, in embodiments of the present invention, in which the direction of initial magnetization is reversed for two regions with respect to X-axis or Y-axis. Fig. 19 illustrates an example of such a configuration in the context of a device generally as illustrated in Fig. 10, wherein the directions of initial magnetization of magneto-resistive elements 15-1 and 14-2 converge inwardly to the centre and those of magneto-resistive elements 14-1 and 15-2 diverge outwardly from the centre. Fig. 20 illustrates such a configuration in the context of a sensing device generally as illustrated in Fig. 16.

In the configurations of Figs. 19 and 20, the direction of initial magnetization for magneto-resistive elements is reversed with respect to the X-axis, one converging to and the other diverging from the centre of through-hole 19. In this case, the direction of initial magnetization becomes unstable (indefinite) in vicinities close to the X-axis, and therefore the meandering patterns of barber-pole type magneto-resistive elements are omitted from such areas, as shown in Figs. 19 and 20.

When such patterns are formed, north and south poles of an electromagnet are placed symmetrically with respect to the X-axis outside the peripheral regions of the patterns and the patterns are magnetized.

When the direction of magnetization is reversed, the magneto-resistive element also changes its polarity; therefore, barber-pole slant direction should be changed in order to maintain an unchanged characteristic for the sensing unit. This can be seen when the slant directions of magneto-resistive elements 15-1 and 14-2 of Fig. 19 are compared with those of Fig. 10. Also, the slant directions of the lower halves of magneto-resistive elements 14-1 and 14-2 in Fig. 20 are reversed as compared with the slant directions in Fig. 16.

Perforation of a through-hole 19 in a substrate, such as shown in Figs. 10, 11, 16, 19 and 20, will now be explained. In order to measure current precisely, a centre conductive wire should be fixed firmly and vertically with respect to the substrate. Because it is troublesome to provide or relocate a conductive wire in and through through-hole 19 every time a measurement is to be made, it is desirable to provide a conductive layer covering through-hole 19 and conductive pads for connections to a load circuit.

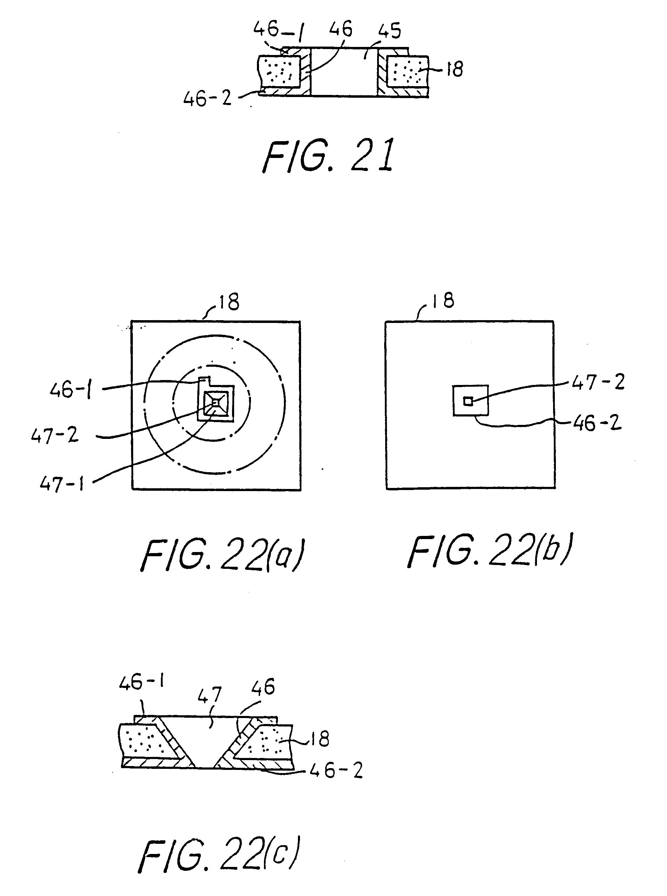

Fig. 21 shows a partial cross-sectional view of a silicon substrate 18, magneto-resistive elements being formed thereon. A circular hole 45 is formed therein, and a metal layer 46 is coated on an inside surface of the whole and on neighbouring regions of both substrate surfaces 46-1 and 46-2 by plating or sputtering. For perforating the through-hole 19, known physical or chemical methods may be used.

It is known that silicon monocrystal exhibits an anisotropic etching characteristic when it is subjected to a heated alkali solution, because the etching rate is different depending on the surface orientation of the silicon substrate. Surfaces (1, 0, 0) and (1, 1, 0) have a high etching rate, but the surface (1, 1, 1) has a low etching rate. Therefore, when a silicon substrate is subjected to anisotropic etching, a surface (1, 1, 1) is exposed and further etching is then inhibited.

Using a silicon wafer having appropriate surface orientation and aligning the sides of a mask pattern with the crystal axis direction, a symmetrical perforation about a centre point can be formed in a silicon substrate after anisotropic etching.

For example, the formation of a perforation of pyramid shape will be explained with reference to Figs. 22(a), 22(b) and 22(c). When a silicon monocrystal substrate 18 having a (1, 0, 0) surface is subjected to anisotropic etching using a square mask pattern, whereby a side of the square pattern is aligned with the <1, 1, 0> direction of the silicon substrate, a perforation 47 of a truncated pyramid shape is formed in the substrate 18. Thereafter, metal layer 46 is deposited on the inner surface of perforation 47, and at the same time, pad portions 46-1 and 46-2 are formed on both main surfaces of the substrate 18.

Details of the manufacturing processes used for forming the above perforation are as follows:-
(a) Silicon substrate 18 is subjected to thermal oxidization, forming a silicon dioxide layer 0.5 to 1.0 µm thick;
(b) A square opening is formed in the silicon dioxide layer by photolithography technology, whereby one side of the square is maintained in parallel with the direction <1, 1, 0> of the silicon substrate;
(c) By anisotropic etching the perforation 47 is formed. The angle of a surface of the perforation is about 55° with respect to a silicon substrate surface, and a truncated pyramid shape perforation is formed which has a comparatively large opening 47-1 on an upper silicon surface and small opening 47-2 on a lower silicon surface. As etching solution, a mixture of ethylene diamine 255 cc, H₂O 120 cc, and catechol 46 gr may be used at 100 to 110°C.
(d) After forming magneto-resistive elements, perforation 47 is covered with metal layer 46.

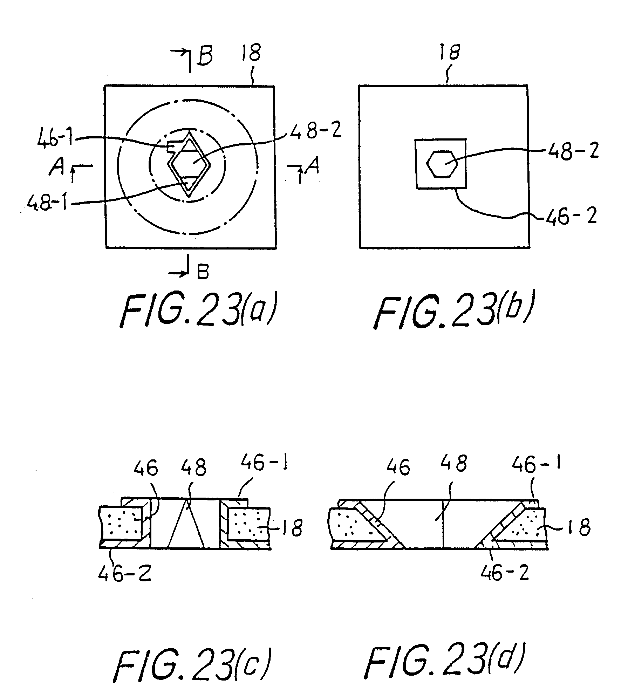

Another procedure for forming a perforation will be explained with reference to Figs. 23(a) through 23(d), where Fig. 23(a) is a top view; Fig. 23(b) a bottom view; Fig. 23(c) a cross-sectional view taken along line A-A in Fig. 23(a) and Fig. 23(d) is a cross-sectional view taken along line B-B in Fig. 23(a).

In this case, silicon monocrystal substrate 18 having a (1, 1, 0) surface is subjected to anisotropic etching, with one side, forming an acute angle of a rhombus-shape mask pattern, being aligned with the direction <1, 1, 1> of silicon substrate 18. From two sides of the mask forming an obtuse angle of the rhombus-shape substrate is etched vertically. However, from two sides of the mask forming an acute angle of the rhombus, silicon substrate is etched with an oblique plane. Therefore, the perforation formed exhibits a rhombus shape 48-1 as in Fig. 23(a) at one main surface of the substrate, but exhibits a hexagon shape 48-2 as in Fig. 23(b) at the other surface of the substrate. Metal layer 46, 46-1 and 46-2 is deposited on the inner surfaces of the perforation and on both silicon side surfaces near the perforation.

As explained above with reference to Figs 6 and 7, sensing devices embodying the present invention can be utilized for detecting or measuring electric power.

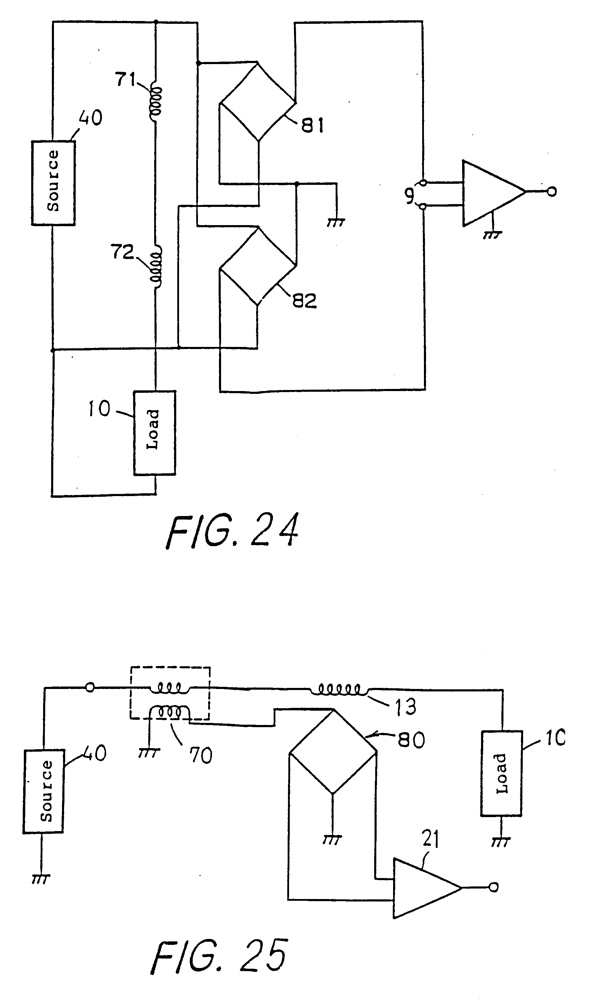

Fig. 24 is a schematic block diagram illustrating another arrangement of sensing devices for measuring electric power in accordance with an embodiment of the present invention.

Two sensing devices 81 and 82 are used. A power source 40 supplies electric current to a load 10 through coils 71 and 72. The two coils 71 and 72 are disposed in such a way that the direction of magnetic field generated by one coil is opposite to that generated by the other, and further, the polarities of sensing devices 81 and 82 are opposite, so the two sensing devices provide twice the output of one sensing device. On the other hand, the effects of the terrestrial magnetic field is cancelled in a combined circuit of two sensing devices 81 and 82, and no output due to terrestrial magnetism is detected.

Fig. 25 is a schematic block diagram of another embodiment of the present invention, wherein an alternating (AC) power source 40 of high voltage is used and an insulation (isolation) transformer 70 is employed. The voltage in the load circuit is reduced to an appropriate value for measurement, by insulation (isolation) transformer 70. This circuit is useful when insulation for the sensing device becomes an important problem.

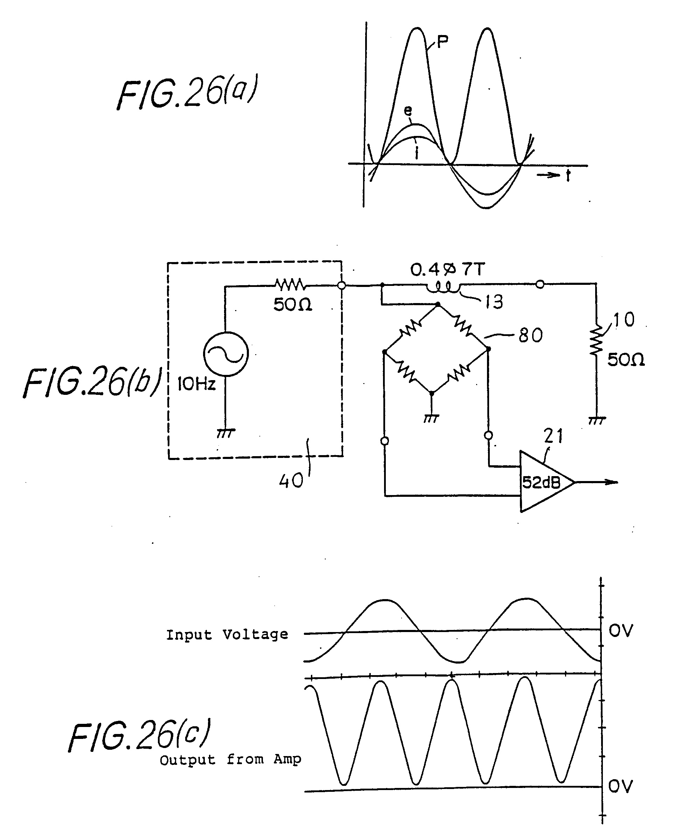

Figs. 26(a), 26(b) and 26(c) show, respectively, waveforms, a circuit diagram, and phase relationship between input voltage and output voltage relating to a sensor circuit for measuring electric power supplied to a pure resistive load. As indicated in Fig. 26(a), current i is in phase with voltage e. Electric power P is a product of voltage v and current i, and therefore, power output waveform should show a fluctuating waveform, wherein the frequency is doubled with respect to the original frequency and the waveform indicates all positive values.

The circuit of Fig. 26(b) used for test utilizes an alternating power source of 10 Hz, having 50 ohms internal impedance, supplying current to a load 10 of 50 ohms impedance. The magnetic field generating means consists of a seven turn coil of 0.4 mm wire diameter. The amplifier has a gain of 52 dB.

The output from amplifier 21 is plotted in Fig. 26(c) with respect to input voltage, which shows that the output waveform has a doubled frequency and exists above the ordinate value of 0 v.

When the load is not a pure resistance, but has an inductance or a capacitance component, the phase of the load current respectively lags or leads with respect to the voltage waveform. Further, the power waveform fluctuates between a positive value and a negative values with respect to the ordinate value 0 v.

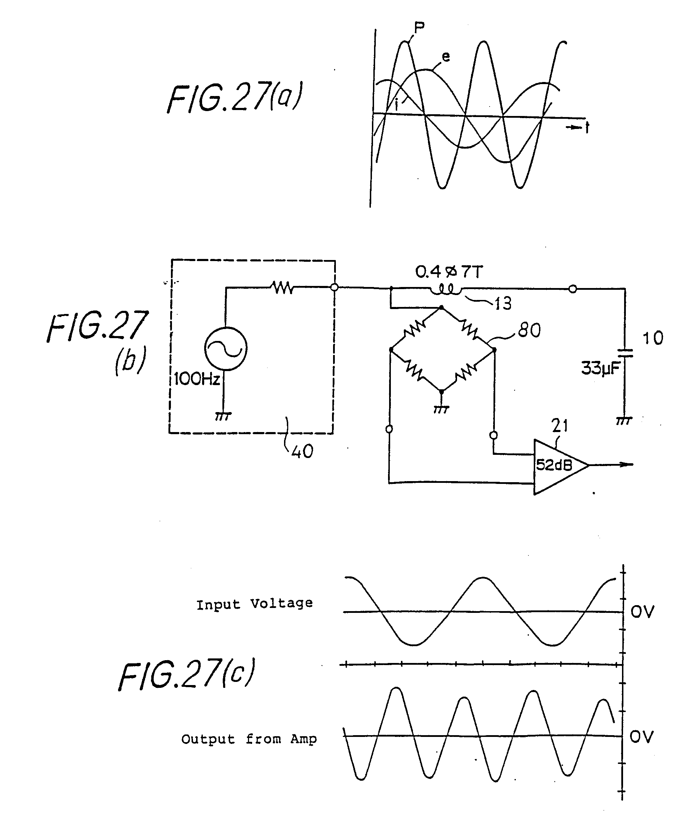

As the simplest case, a load of a pure capacitive nature was used and tested. The relationship between voltage and current is as shown in Fig. 27(a). Current waveform i is 90° in advance of voltage e. Power waveform P has a doubled frequency and fluctuates between a positive value and an equal negative value with respect to ordinate 0.

Using a circuit as shown in Fig. 27(b), similar to that of Fig. 26(b), except that the load is a capacitance and the frequency is changed to 100 Hz, tests results were as shown in Fig. 27(c). The waveform output from amplifier 27 in Fig. 27(c) shows that when the power is integrated over a plurality of periods, it converges to zero, which means that the power is wattless power. To measure directly the effective power consumed in the load circuit an integration circuit after amplifier 21 indicates the effective power.

Sensing devices embodying the present invention, as explained previously, are of compact size with no moving parts, and moreover frequency characteristics are superior. In general, magneto-resistive elements have better characteristics when subjected to temperature rises than do Hall-effect elements.

In an embodiment of the present invention a magneto electric transducer such as a Hall-effect element or a magneto-resistive element is utilized in a sensing device for a measurement of electric current or electric power. A sensing device embodying the present invention utilizes a plurality of magneto electric transducers disposed in close proximity to a conductive wire through which electric current flows. A magneto-resistive element of barber-pole type is especially suitable for forming a plurality of elements on a substrate. Structures employing four magneto-resistive elements forming a bridge circuit, or employing a plurality of magneto-resistive elements connected in series, may be used, wherein magneto-resistive elements are of barber-pole type, with meandering patterns, arranged in doughnut ring shape. The conductive wire may be provided parallel to the substrate or to penetrate through a through-hole located at the centre of a plurality of magneto-resistive element patterns. A sensing device embodying the present invention can have a compact size and can be used for the measurement of both direct current and high frequency current.

## Claims

1. A sensing device utilizing magneto-resistive elements of a barber-pole type, said device comprising:-
a conductive member (11, 13), for example a conductive wire (11), through which an electric current to be sensed flows, generating a magnetic field around said conductive member (11, 13);
a substrate (18);
a plurality of said magneto-resistive elements (14-1, 14-2, 15-1, 15-2) formed on the substrate (18), each or at least one of which elements has a function of outputting an electrical signal responsive to said magnetic field;
means (19) for locating the conductive member (11, 13) in close proximity to said magneto-resistive elements (14-1, 14-2, 15-1, 15-2), or to said at least one of the elements; and
means (16, 21, 20, Tb, 22-1, 22-2, 22-3, 22-4, 30) for combining electrical signals output from the magneto-resistive elements (14-1, 14-2, 15-1, 15-2) and outputting a combined signal the value of which is dependent upon the said electric current;
characterised in that
the magneto-resistive elements (14-1, 14-2, 15-1, 15-2) of the plurality are arranged in a doughnut-ring shape around a central region and each magneto-resistive element of the plurality has a meandering pattern, said pattern comprising alternate outward strips, going away from said central region almost along a radial direction, and return strips going back towards said central region.

2. A sensing device as claimed in claim 1, wherein said plurality of magneto-resistive elements (14-1, 14-2, 15-1, 15-2) is, in operation, connected to a constant current/voltage source, and said combined signal comprises a variable component which depends on said electric current only.

3. A sensing device as claimed in claim 1, wherein said plurality of magneto-resistive elements (14-1, 14-2, 15-1, 15-2) is, in operation, connected to a power source which also supplies said electric current to a load through said conductive member (11, 13) and said combined signal comprises a variable component which depends on a product of a voltage of said power source and said electric current.

4. A sensing device as claimed in claim 1, 2 or 3, wherein magneto-resistive elements of said plurality are arranged at circumferentially diametrically opposite positions about said conductive member (11, 13).

5. A sensing device as claimed in any preceding claim, wherein said conductive member (11) intersects said substrate (18) vertically in said central region.

6. A sensing device as claimed in any preceding claim, wherein each said strip of said meandering pattern of a magneto-resistive element extends longitudinally at an angle of less than 5° to a line radially drawn from said central region.

7. A sensing device as claimed in any preceding claim, wherein each said strip of said meandering pattern of a magneto-resistive element has the same width irrelevant of distance from said central region.

8. A sensing device as claimed in any of claims 1 to 6, wherein each said strip of said meandering pattern of a magneto-resistive element has a width which increases gradually with increasing distance from said central region.

9. A sensing device as claimed in any preceding claim, wherein four magneto-resistive elements form a bridge circuit, and an unbalanced current of said bridge circuit is utilized as said combined signal.

10. A sensing device as claimed in any of claims 1 to 8, wherein at least two magneto-resistive elements connected in series are utilized, and voltage drops across said magneto resistive elements are combined to form said combined signal.

11. A sensing device as claimed in any preceding claim, wherein all the magneto-resistive elements are subjected to an initial magnetization, the direction thereof either diverging from said central region or converging to said central region.

12. A sensing device as claimed in any of claims 1 to 10, wherein said plurality of magneto-resistive elements is grouped by either X-axis or Y-axis into two groups, members of the first group being subjected to an initial magnetization having a direction diverging from said central region, and members of said second group being subjected to an initial magnetization having a direction of converging to said central region.

13. A sensing device as claimed in claim 5, or any of claims 6 to 12 read as appended to claim 5, wherein said conductive member (11, 13), for example a conductive wire (11), penetrates through a through-hole (19) formed in said substrate (18), said through-hole being formed by a microscopic processing technology.

14. A sensing device as claimed in claim 13, wherein said through-hole is formed by an etching technology.

15. A sensing device as claimed in claim 5, or any of claims 6 to 12 read as appended to claim 5, wherein said conductive member (11, 13), for example a conductive wire (11), crosses said substrate (18) via a conductive layer deposited on an inner surface of a through-hole (19) formed in said substrate (18), and said conductive wire is connected to both end surfaces of said conductive layer.

16. A sensing device as claimed in claim 13, 14 or 15, wherein said through-hole is formed by a wet anisotropic etching technology.

17. A sensing device as claimed in claim 16, wherein said substrate (18) is of silicon crystal having a (1, 1, 0) surface, and said through-hole has a rhombus shape at the first main surface of said silicon substrate and a hexagon shape at the second main surface thereof.

18. A sensing device as claimed in claim 16, wherein said substrate (18) is of silicon crystal having a (1, 0, 0) surface, and said through-hole exhibits a truncated pyramid shape.

19. A sensing device as claimed in any one of claims 1 to 4, wherein said means for locating said conductive member further comprises means for holding said conductive member parallel to a plane in which the plurality of magneto-resistive elements is disposed.

20. A sensing device as claimed in claim 19, wherein said conductive member (11) is of a ribbon wire type.

21. A sensing device as claimed in claim 3, or any one of claims 4 to 20 read as appended to claim 3, wherein said plurality of magneto-resistive elements are connected to said power source, being an alternating current source, via an insulation transformer.

22. A sensing device as claimed in claim 21, wherein said combined signal, comprising a variable component, is further integrated to provide an output representing effective electrical power.

## Patentansprüche

1. Fühlanordnung, bei welcher magnetoresistive Elemente von einem Magneto-Widerstandskopf-Typ verwendet werden, wobei die genannte Anordnung umfaßt:
einen leitenden Teil (11, 13), beispielsweise einen leitenden Draht (11), durch welchen ein zu fühlender elektrischer Strom fließt, der ein Magnetfeld rund um den genannten leitenden Teil (11, 13) erzeugt;
ein Substrat (8);
eine Vielzahl der genannten magnetoresistiven Elemente (14-1, 14-2, 15-1, 15-2), die auf dem Substrat (18) gebildet sind, wobei jedes oder zumindest eines dieser Elemente eine Funktion zur Ausgabe eines elektrischen Signals aufweist, ansprechend auf das genannte Magnetfeld;
eine Einrichtung (19) zum Anordnen des leitenden Teils (11, 13) in unmittelbarer Nähe zu den genannten magnetoresistiven Elementen (14-1, 14-2, 15-1, 15-2) oder zum genannten zumindest einen der Elemente; und
Einrichtungen (16, 21, 20, Tb, 22-1, 22-2, 22-3, 22-4, 30) zur Kombination elektrischer Signale, die aus den magnetoresistiven Elementen (14-1, 14-2, 15-1, 15-2) ausgegeben werden, und zur Ausgabe eines kombinierten Signals, dessen Wert vom genannten elektrischen Strom abhängig ist;
dadurch gekennzeichnet, daß die magnetoresistiven Elemente (14-1, 14-2, 15-1, 15-2) der Vielzahl in einer Ringform rund um eine zentrale Zone angeordnet sind, und jedes magnetoresistive Element der Vielzahl ein Mäandermuster aufweist, wobei das genannte Muster alternierend nach außen gerichtete Streifen, die von der genannten zentralen Zone nahezu in radialer Richtung wegführen, und Rücklaufstreifen umfaßt, die zur zentralen Zone zurückführen.

2. Fühlanordnung nach Anspruch 1, bei welcher die genannte Vielzahl magnetoresistiver Elemente (14-1, 14-2, 15-1, 15-2) im Betrieb mit einer Konstantstrom/Spannungsquelle verbunden ist, und das genannte kombinierte Signal eine variable Komponente umfaßt, die ausschließlich vom genannten elektrischen Strom abhängig ist.

3. Fühlanordnung nach Anspruch 1, bei welcher die genannte Vielzahl magnetoresistiver Elemente (14-1, 14-2, 15-1, 15-2) im Betrieb mit einer Energiequelle verbunden ist, die auch den genannten elektrischen Strom durch den genannten leitenden Teil (11, 13) einer Last zuführt, und das genannte kombinierte Signal eine variable Komponente umfaßt, die von einem Produkt einer Spannung der genannten Energiequelle und dem genannten elektrischen Strom abhängig ist.

4. Fühlanordnung nach Anspruch 1, 2 oder 3, bei welcher magnetoresistive Elemente der genannten Vielzahl in in Umfangsrichtung diametral entgegengesetzten Position rund um den genannten leitenden Teil (11, 13) angeordnet sind.

5. Fühlanordnung nach einem der vorhergehenden Ansprüche, bei welcher der genannte leitende Teil (11) das genannte Substrat (18) vertikal in der zentralen Zone schneidet.

6. Fühlanordnung nach einem der vorhergehenden Ansprüche, bei welcher sich jeder genannte Streifen des genannten Mäandermusters eines magnetoresistiven Elements in Längsrichtung unter einem Winkel von weniger als 5° zu einer radial von der genannten zentralen Zone gezogenen Linie erstreckt.

7. Fühlanordnung nach einem der vorhergehenden Ansprüche, bei welcher jeder genannte Streifen des genannten Mäandermusters eines magnetoresistiven Elements ungeachtet der Distanz von der zentralen Zone die gleiche Breite aufweist.

8. Fühlanordnung nach einem der Ansprüche 1 bis 6, bei welcher jeder genannte Streifen des genannten Mäandermusters eines magnetoresistiven Elements eine Breite aufweist, die sich allmählich mit zunehmender Distanz von der genannten zentralen Zone erhöht.

9. Fühlanordnung nach einem der vorhergehenden Ansprüche, bei welcher vier magnetoresistive Elemente eine Brückenschaltung bilden, und ein unsymmetrischer Strom der genannten Brückenschaltung als genanntes kombiniertes Signal verwendet wird.

10. Fühlanordnung nach einem der Ansprüche 1 bis 8, bei welcher zumindest zwei in Serie geschaltete magnetoresistive Elemente verwendet und Spannungsabfälle über die genannten magnetoresistiven Elemente kombiniert werden, um das genannte kombinierte Signal zu bilden.

11. Fühlanordnung nach einem der vorhergehenden Ansprüche, bei welcher alle magnetoresistiven Elemente einer anfänglichen Magnetisierung ausgesetzt werden, deren Richtung entweder von der genannten zentralen Zone divergiert oder zur genannten zentralen Zone konvergiert.

12. Fühlanordnung nach einem der Ansprüche 1 bis 10, bei welcher die genannte Vielzahl magnetoresistiver Elemente entweder durch die X-Achse oder die Y-Achse in zwei Gruppen eingeteilt wird, wobei Mitglieder der ersten Gruppe einer anfänglichen Magnetisierung ausgesetzt werden, welche eine Richtung aufweist, die von der genannten zentralen Zone divergiert, und Mitglieder der zweiten Gruppe einer anfänglichen Magnetisierung ausgesetzt werden, welche eine Richtung aufweist, die zur genannten zentralen Zone konvergiert.

13. Fühlanordnung nach Anspruch 5 oder nach einem der Ansprüche 6 bis 12, wie auf Anspruch 5 rückbezogen, bei welcher der genannte leitende Teil (11, 13), beispielsweise ein leitender Draht (11), ein im Substrat (18) gebildetes Durchgangsloch (19) durchdringt, wobei das genannte Durchgangsloch durch eine mikroskopische Bearbeitungstechnologie gebildet wird.

14. Fühlanordnung nach Anspruch 13, bei welcher das genannte Durchgangsloch durch eine Ätztechnologie gebildet wird.

15. Fühlanordnung nach Anspruch 5 oder nach einem der Ansprüche 6 bis 12, wie auf Anspruch 5 rückbezogen, bei welcher der genannte leitende Teil (11, 13), beispielsweise ein leitender Draht (11), das genannte Substrat (18) über eine leitende Schicht kreuzt, die an einer Innenfläche eines im genannten Substrat (18) gebildeten Durchgangslochs (19) abgeschieden ist, und der genannte leitende Draht mit beiden Endflächen der genannten leitenden Schicht verbunden ist.

16. Fühlanordnung nach Anspruch 13, 14 oder 15, bei welcher das genannte Durchgangsloch durch eine anisotrope Naßätztechnologie gebildet wird.

17. Fühlanordnung nach Anspruch 16, bei welcher das genannte Substrat (18) aus Siliziumkristall mit einer (1, 1, 0) Oberfläche besteht, und das genannte Durchgangsloch eine Rhombusform an der ersten Hauptfläche des genannten Siliziumsubstrats und eine Hexagonform an der zweiten Hauptfläche hiervon aufweist.

18. Fühlanordnung nach Anspruch 16, bei welcher das genannte Substrat (18) aus Siliziumkristall mit einer (1, 1, 0) Oberfläche besteht, und das genannte Durchgangsloch eine Pyramidenstumpfform aufweist.

19. Fühlanordnung nach einem der Ansprüche 1 bis 4, bei welcher die genannte Einrichtung zum Anordnen des genannten leitenden Teils ferner Einrichtungen zum Halten des genannten leitenden Teils parallel zu einer Ebene umfaßt, in der die Vielzahl magnetoresistiver Elemente angeordnet ist.

20. Fühlanordnung nach Anspruch 19, bei welcher der genannte leitende Teil (11) von einem Banddraht-Typ ist.

21. Fühlanordnung nach Anspruch 3 oder einem der Ansprüche 4 bis 20, wie auf Anspruch 3 rückbezogen, bei welcher die genannte Vielzahl magnetoresistiver Elemente mit der genannten Energiequelle, die eine Wechselstromquelle ist, über einen Trennwandler verbunden ist.

22. Fühlanordnung nach Anspruch 21, bei welcher das genannte kombinierte Signal, das eine variable Komponente umfaßt, ferner integriert ist, um einen wirksame elektrische Energie repräsentierenden Ausgang vorzusehen.

## Revendications

1. Dispositif de détection utilisant des éléments magnéto-résistifs du type à bandes inclinées, ce dispositif comportant :
une pièce conductrice (11, 13), par exemple un fil conducteur (11) dans lequel circule un courant électrique qui doit être détecté, développant un champ magnétique autour de ladite pièce conductrice (11, 13);
un substrat (18) ;
plusieurs desdits éléments magnéto-résistifs (14-1, 14-2, 15-1, 15-2) formés sur le substrat (18), chacun ou l'un au moins desdits éléments ayant une fonction d'émettre un signal électrique en fonction dudit champ magnétique ;
un dispositif (19) destiné à positionner la pièce conductrice (11, 13) en toute proximité desdits éléments magnéto-résistifs (14-1, 14-2, 15-1, 15-2) ou au moins de l'un desdits éléments ; et
un dispositif (16, 21, 20, Tb, 22-1, 22-2, 22-3, 22-4, 30) destiné à combiner des signaux électriques émis par les éléments magnéto-résistifs (14-1, 14-2, 15-1, 15-2) et à émettre un signal combiné dont la valeur dépend dudit courant électrique ;
caractérisé en ce que :
les éléments magnéto-résistifs (14-1, 14-2, 15-1, 15-2) parmi les plusieurs sont disposés en forme torique autour d'une région centrale et chaque élément magnéto-résistif parmi les plusieurs a une configuration sinueuse, ladite configuration comprenant des bandes extérieures alternées partant de ladite région centrale, presque le long d'une direction radiale et des bandes de retour revenant vers ladite région centrale.

2. Dispositif de détection selon la revendication 1, dans lequel lesdits plusieurs éléments magnéto-résistifs (14-1, 14-2, 15-1, 15-2) sont, en fonctionnement, connectés à une source de courant ou de tension constant et ledit signal combiné comporte une composante variable qui dépend seulement dudit courant électrique.

3. Dispositif de détection selon la revendication 1, dans lequel lesdits plusieurs éléments magnéto-résistifs (14-1, 14-2, 15-1, 15-2) sont, en fonctionnement, connectés à une source d'alimentation qui fournit également ledit courant électrique à une charge par ladite pièce conductrice (11, 13) et ledit signal combiné consiste en une composante variable qui dépend du produit de la tension de ladite source d'alimentation et dudit courant électrique.

4. Dispositif de détection selon la revendication 1, 2 ou 3, dans lequel lesdits éléments résistifs parmi les plusieurs sont disposés dans des positions opposées diamétralement et circonférentiellement autour de ladite pièce conductrice (11, 13).

5. Dispositif de détection selon l'une quelconque des revendications précédentes, dans lequel ladite pièce conductrice (11) coupe ledit substrat (18) verticalement, dans ladite région centrale.

6. Dispositif de détection selon l'une quelconque des revendications précédentes, dans lequel chacune desdites bandes de ladite configuration sinueuse d'un élément magnéto-résistif s'étend dans la direction longitudinale sous un angle inférieur à 5° par rapport à une ligne tracée radialement à partir de ladite région centrale.

7. Dispositif selon l'une quelconque des revendications précédentes, dans lequel chacune desdites bandes de ladite configuration sinueuse d'un élément magnéto-résistif a la même largeur indépendamment de la distance de ladite région centrale.

8. Dispositif de détection selon l'une quelconque des revendications 1 à 6, dans lequel chacune desdites bandes de ladite configuration sinueuse d'un élément magnéto-résistif a une largeur qui augmente progressivement avec une distance qui augmente à partir de ladite région centrale.

9. Dispositif de détection selon l'une quelconque des revendications précédentes, dans lequel quatre éléments magnéto-résistifs forment un circuit en pont et un courant déséquilibré dudit circuit en pont est utilisé comme ledit signal combiné.

10. Dispositif de détection selon l'une quelconque des revendications 1 à 8, dans lequel au moins deux éléments magnéto-résistifs connectés en série sont utilisés et les chutes de tension aux bornes desdits éléments magnéto-résistifs sont combinées pour former ledit signal combiné.

11. Dispositif de détection selon l'une quelconque des revendications précédentes, dans lequel tous les éléments magnéto-résistifs sont soumis à une magnétisation initiale, dont la direction est divergente à partir de ladite région centrale ou convergente vers ladite région centrale.

12. Dispositif de détection selon l'une quelconque des revendications 1 à 10, dans lequel lesdits plusieurs éléments magnéto-résistifs sont groupés en deux groupes, soit par l'axe X, soit par l'axe Y, les éléments du premier groupe étant soumis à une magnétisation initiale dont la direction diverge à partir de ladite région centrale et les éléments dudit second groupe étant soumis à une magnétisation initiale dont la direction converge vers ladite région centrale.

13. Dispositif de détection selon la revendication 5 ou l'une quelconque des revendications 6 à 10, lue comme annexée à la revendication 5, dans lequel ladite pièce conductrice (11, 13), par exemple un fil conducteur (11), pénètre par un trou de traversée (19) formé dans ledit substrat (18), ledit trou de traversée étant formé par une technologie de traitement microscopique.

14. Dispositif de détection selon la revendication 13, dans lequel ledit trou de traversée est formé par une technologie de gravure.

15. Dispositif de détection selon la revendication 5 ou l'une quelconque des revendications 6 à 12, lue telle qu'annexée à la revendication 5, dans lequel ladite pièce conductrice (11, 13), par exemple un fil conducteur (11), traverse ledit substrat (18) par l'intermédiaire d'une couche conductrice déposée sur une surface intérieure d'un trou de traversée (19) formé dans ledit substrat (18) et ledit fil conducteur est connecté aux deux surfaces d'extrémité de ladite couche conductrice.

16. Dispositif de détection selon la revendication 13, 14 ou 15, dans lequel ledit trou de traversée est formé par une technologie de gravure anisotrope humide.

17. Dispositif de détection selon la revendication 16, dans lequel ledit substrat (18) est un cristal de silicium ayant une surface (1, 1, 0) et ledit trou de traversée a une forme rhomboïdale à la première surface principale dudit substrat de silicium et une forme hexagonale à sa seconde surface principale.

18. Dispositif de détection selon la revendication 16, dans lequel ledit substrat (18) est un cristal de silicium ayant une surface (1, 0, 0), et ledit trou de traversée présente une forme de pyramide tronquée.

19. Dispositif de détection selon l'une quelconque des revendications 1 à 4, dans lequel ledit dispositif de localisation de ladite pièce conductrice comporte en outre un dispositif destiné à maintenir ladite pièce conductrice parallèle à un plan dans lequel sont disposés les plusieurs éléments magnéto-résistifs.

20. Dispositif de détection selon la revendication 19, dans lequel ladite pièce conductrice (11) est d'un type à fil en ruban.

21. Dispositif de détection selon la revendication 3 ou l'une quelconque des revendications 4 à 20 lue telle qu'annexée à la revendication 3, dans lequel lesdits plusieurs éléments magnéto-résistifs sont connectés à ladite source d'alimentation, cette dernière étant une source de courant alternatif, par l'intermédiaire d'un transformateur d'isolement.

22. Dispositif de détection selon la revendication 21, dans lequel ledit signal combiné, contenant une composante variable, est en outre intégré pour fournir un signal de sortie représentant une puissance électrique effective.
